(19) Europäisches Patentamt / European Patent Office / Office européen des brevets

(11) **EP 2 579 329 A1**

(12) **EUROPEAN PATENT APPLICATION**
published in accordance with Art. 153(4) EPC

(43) Date of publication:
**10.04.2013 Bulletin 2013/15**

(21) Application number: **11786650.9**

(22) Date of filing: **24.05.2011**

(51) Int Cl.:
*H01L 31/042* (2006.01)   *C09K 3/10* (2006.01)

(86) International application number:
**PCT/JP2011/061903**

(87) International publication number:
**WO 2011/148951 (01.12.2011 Gazette 2011/48)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.05.2010   JP 2010120647**

(71) Applicant: **Hitachi Chemical Company, Ltd.
Tokyo 163-0449 (JP)**

(72) Inventors:
• **SAWAKI, Taku
Tsukuba-shi
Ibaraki 300-4247 (JP)**

• **OKANIWA, Kaoru
Tsukuba-shi
Ibaraki 300-4247 (JP)**
• **YAMASHITA, Takeshi
Tsukuba-shi
Ibaraki 300-4247 (JP)**

(74) Representative: **Albrecht, Thomas
Kraus & Weisert
Patent- und Rechtsanwälte
Thomas-Wimmer-Ring 15
80539 München (DE)**

(54) **WAVELENGTH CONVERSION-TYPE SOLAR CELL SEALING MATERIAL, AND SOLAR CELL MODULE**

(57) A wavelength conversion type photovoltaic cell sealing material according to the present invention includes a first sealing layer that contains no fluorescent substance and a second sealing layer that contains a fluorescent substance. This wavelength conversion type photovoltaic cell sealing material is used as one of the light transmissive layers of a photovoltaic cell module and is disposed at a light receiving surface side of a solar cell.

[Fig. 1]

EP 2 579 329 A1

**Description**

[Technical Field]

The present invention relates to a wavelength conversion type photovoltaic cell sealing material and a photovoltaic cell module in which it is used. In further detail, the present invention relates to a wavelength conversion type photovoltaic cell sealing material used in a photovoltaic cell module which can enhance electricity generation efficiency by converting the wavelength of light in a wavelength region that does not contribute to electricity generation into that of light in a wavelength region that contributes to electricity generation using a fluorescent substance (also referred to as a light emitting material) and to a photovoltaic cell module.

[Background Art]

Silicon crystal-based photovoltaic cell modules in the related art have such a configuration as described below. As a protective glass (also referred to as a cover glass) on its surface, a tempered glass is used for placing importance on shock resistance, and a pattern with recesses and projections is applied to one side thereof by embossment in order to improve adhesiveness with a sealing material (usually, a resin which contains an ethylene-vinyl acetate copolymer as a main component; also referred to as a filler).

In addition, the pattern with recesses and projections is formed on its internal side and the surface of the photovoltaic cell module is smooth. A shape with recesses and projections may also be applied to its external side in order to enhance the efficiency of introducing sunlight. In addition, a solar cell, a sealing material for protecting and sealing a tab line, and a back film are disposed on the underside of the protective glass.

There have been suggested a number of techniques, such as that in Japanese Patent Laid-Open No. 2000-328053, for disposing a layer which emits light in a wavelength region that contributes significantly to electricity generation, in the light-receiving surface side of a photovoltaic cell, by using a fluorescent substance and converting the wavelength of light in the ultraviolet region or in the infrared region that contributes less to electricity generation in the sunlight spectrum.

There have also been suggested, in Japanese Patent Laid-Open No. 2006-303033, a method for incorporating a rare earth complex, which is a fluorescent substance, as a wavelength conversion material, into a sealing material.

SUMMARY OF INVENTION

[Technical Problem]

In the above-mentioned method for converting the wavelength of light in a wavelength region that contributes less to electricity generation into that of light in a wavelength region that contributes significantly to electricity generation, as described in Japanese Patent Laid-Open No. 2006-303033, the wavelength conversion layer contains the fluorescent substance. As the fluorescent substance, an organic fluorescent body, an organometallic complex or an inorganic fluorescent body, which is expensive, is used. In addition, when the wavelength conversion layer is used as the sealing material, its film thickness of around 600 $\mu$m is required from the viewpoint of protecting the cell.

However, when the sealing material containing the fluorescent substance having a sufficient wavelength conversion effect is produced in a thickness of 600 $\mu$m, the content of the fluorescent substance is increased, so that its cost is inevitably increased and it is not always appropriate to industrially use it.

Thus, the present invention addresses the problem of providing an inexpensive wavelength conversion type photovoltaic cell sealing material while maintaining or improving electricity generation efficiency when it is applied to a photovoltaic cell module.

[Solution to Problem]

As a result of intensive research into the above-described problem, the present inventors found that electricity generation efficiency equivalent to or greater than that in the case of a large film thickness is exhibited even in the case of a small film thickness, when the ratio of generated electric power to incident sunlight (electricity generation efficiency) is compared between wavelength conversion layers with small and large film thicknesses but including fluorescent substances at the same concentration. In view of this result, it was found that a cost reduction can be achieved while maintaining or improving the electricity generation efficiency when a sealing material layer on the light-receiving side of a wavelength conversion type photovoltaic cell module is formed so as to be divided into two layers, one layer containing a fluorescent substance and one layer containing no fluorescent substance.

Specifically, the present invention is as follows.

<1> A wavelength conversion type photovoltaic cell sealing material including a first sealing layer that contains no fluorescent substance and a second sealing layer that contains a fluorescent substance.

<2> The wavelength conversion type photovoltaic cell sealing material according to <1> as described above, wherein the fluorescent substance is a europium complex.

<3> The wavelength conversion type photovoltaic cell sealing material according to <1> or <2> as described above, wherein the fluorescent substance is contained in a resin particle with a vinyl compound as a monomer compound.

<4> A photovoltaic cell module including:

a solar cell; and

the wavelength conversion type photovoltaic cell sealing material according to any one of <1> to <3> as described above, disposed at a light-receiving surface side of the solar cell.

[Advantageous Effects of Invention]

In accordance with the present invention, there can be provided an inexpensive wavelength conversion type photovoltaic cell sealing material while maintaining or improving electricity generation efficiency when it is applied to a photovoltaic cell module.

BRIEF DESCRIPTION OF DRAWINGS

Fig. 1 is a schematic cross-sectional view illustrating a photovoltaic cell module according to the present invention.
Fig. 2 is a graph indicating the relationships between the film thicknesses of wavelength conversion type photovoltaic cell sealing materials obtained in Examples and Comparative Examples and ΔJsc.

DESCRIPTION OF EMBODIMENTS

A photovoltaic cell module according to the present invention includes at least a solar cell and a wavelength conversion type photovoltaic cell sealing material (wavelength conversion type photovoltaic cell sealing sheet) disposed as one of light transmissive layers in the light-receiving surface side of the photovoltaic cell. In accordance with the present invention, the wavelength conversion type photovoltaic cell sealing material (hereinafter may be simply referred to as "sealing material") is formed by laminating a first sealing layer that contains no fluorescent substance and a second sealing layer that contains a fluorescent substance. The first sealing layer that contains no fluorescent substance may be formed to include one layer or two or more layers whereas the second sealing layer that contains the fluorescent substance is preferably constituted by one layer from the viewpoint of a cost or the simplification of a production process.

Since the wavelength conversion type photovoltaic cell sealing material is constituted by the first sealing layer that contains no fluorescent substance and the second sealing layer that contains the fluorescent substance, the content of the fluorescent substance can be reduced to make a production cost lower than that in the related art. Also, electricity generation efficiency is maintained or improved due to the wavelength conversion type photovoltaic cell sealing material having such a two-layer structure although the content of the fluorescent substance is reduced. The reason for this is not clear but is supposed as described below.

When light is incident on the photovoltaic cell module, the fluorescent substance contained in the sealing material disposed at the light-receiving surface side absorbs light. When this occurs, it is supposed that the absorption of light by the fluorescent substance diminishes as the depth in the film thickness direction of the sealing material increases. Thus, the fluorescent substance present at a deeper portion in the film thickness direction is considered to contribute less to wavelength conversion even if the film thickness of the sealing material is increased. In fact, by comparing sealing materials having fluorescent substances at the same concentration but having different film thicknesses, it was found that electricity generation efficiency equivalent to or greater than that in the case of a large film thickness is exhibited even in the case of a small film thickness.

Further, the reduction in the content of the fluorescent substance suppresses the scattering of light due to the fluorescent substance and increases visible light transmittance. Thus, the quantity of light arriving at the solar cell is increased, the efficiency for utilization of light by the photovoltaic cell module is enhanced, and electricity generation efficiency can be improved.

In the wavelength conversion type photovoltaic cell sealing material according to the present invention, the total thickness of the first sealing layer and the second sealing layer is preferably 10 μm to 1000 μm from the viewpoint of a sealing effect, and more preferably 200 μm to 800 μm.
In addition, the thickness of the second sealing layer that contains the fluorescent substance is preferably 1 μm to 800

μm, and more preferably 10 μm to 600 μm, from the viewpoint of wavelength conversion efficiency.

Further, the rate of the thickness of the second sealing layer that contains the fluorescent substance to the total thickness of the first sealing layer and the second sealing layer is preferably 0.1% to 80%, and more preferably 1% to 50%.

The concentration of the fluorescent substance in the second sealing layer that contains the fluorescent substance is desirably appropriately adjusted depending on the kind of the fluorescent substance. In general, the content of the fluorescent substance in the second sealing layer is preferably 0.00001 to 30 parts by mass, and more preferably 0.0001 to 10 parts by mass, based on 100 parts by mass of a dispersion medium resin. Wavelength conversion efficiency becomes more sufficient due to 0.0001 part by mass or more, and reduction in the quantity of light arriving at the solar cell can be more suppressed due to 10 parts by mass or less.

The photovoltaic cell module according to the present invention will be explained with further reference to the drawings.

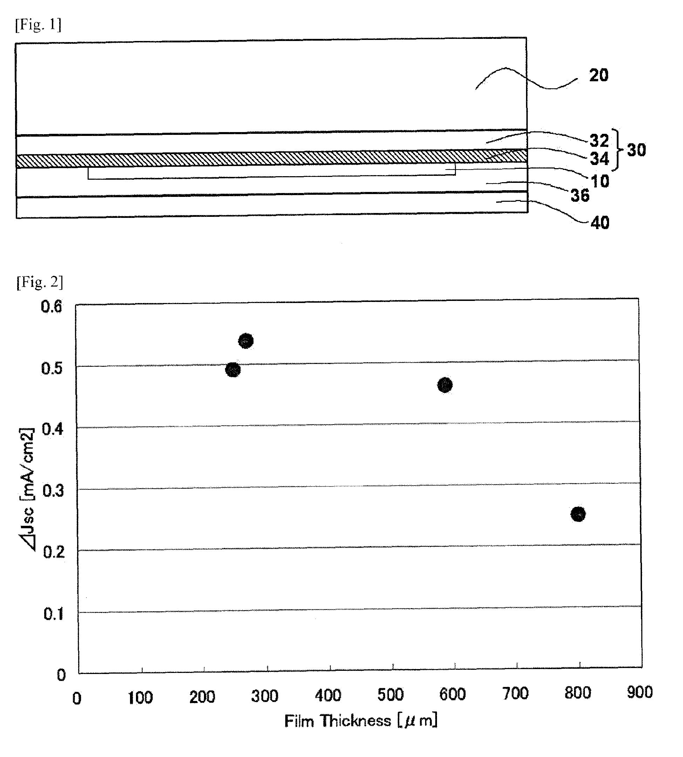

Fig. 1 is the schematic cross-sectional view of the photovoltaic cell module according to the present invention. In the photovoltaic cell module in Fig. 1, a protective glass (also referred to as a cover glass) 20 is provided on the surface of the light-receiving surface side of a solar cell 10. For the protective glass 20, a tempered glass is preferably used, without particular limitation, in consideration of shock resistance. A pattern with recesses and projections is preferably applied to the surface of the sealing material side of the protective glass 20 by embossment in order to improve adhesiveness with a sealing material (also referred to as a filler) as described below. The light-receiving side surface of the protective glass 20 may be smooth or may be applied with a shape with recesses and projections to enhance the efficiency of introducing sunlight.

The sealing material 30 is provided between the protective glass 20 and the solar cell 10. The sealing material 30 in Fig. 1 includes two layers, in which the first sealing layer 32 in a light incident side is a layer that contains no fluorescent substance and the second sealing layer 34 in a side closer to the solar cell 10 is a layer that contains a fluorescent substance. The details of materials constituting the sealing material 30 are described below.

The photovoltaic cell module includes a back film 40 in the back surface side of the solar cell 10. A sealing material 36 for a back surface, for protecting and sealing the solar cell from shock from the back surface of the module, is provided between the back film 40 and the solar cell 10. To the sealing material 36 for a back surface, which is not particularly limited if being able to protect the solar cell, for example, the same as in the first sealing layer 32 that contains no fluorescent substance can also be applied.

Without illustration in Fig. 1, the photovoltaic cell module according to the present invention may also further include a member, such as an anti-reflection film, which is usually disposed in a photovoltaic cell module.

<Wavelength Conversion Type Photovoltaic Cell Sealing Material>

Substances used in the wavelength conversion type photovoltaic cell sealing material according to the present invention will be explained in detail below.

(Fluorescent Substance)

Preferable fluorescent substances used in accordance with the present invention include organic complexes of rare earth metals. Especially, a europium complex or a samarium complex is preferred, and a europium complex is more preferred.
A photovoltaic cell module having high electricity generation efficiency can be realized by using a europium complex as a fluorescent substance. The europium complex converts light in the ultraviolet region into light in the red wavelength region at high wavelength conversion efficiency and the converted light contributes to electricity generation in a solar cell.

In a europium complex, europium (Eu) as the central element as well as molecules that serve as ligands are needed; however, in accordance with the present invention, the kind of the ligand is not limited, and any molecule that forms a complex with europium may be used.

As an example of fluorescent substances formed from such a europium complex, a rare earth complex such as Eu (TTA)$_3$phen can be used. In regard to a method for producing Eu (TTA)$_3$Phen, reference can be made to, for example, the method disclosed in Masaya Mitsuishi, Shinji Kikuchi, Tokuji Miyashita, Yutaka Amano, J. Mater. Chem. 2003, 13, 2875-2879.

In accordance with the present invention, the ligand of the complex is not limited, but a carboxylic acid, a nitrogen-containing organic compound, a nitrogen-containing aromatic heterocyclic compound, a β-diketone or a phosphine oxide is preferred as a neutral ligand.

As the ligand of the rare earth complex, a β-diketone may also be contained, which is represented by the general formula: R$^1$COCHR$^2$COR$^3$ (wherein R$^1$ represents an aryl group, an alkyl group, a cycloalkyl group, a cycloalkylalkyl group, an aralkyl group or a substitution product thereof; R$^2$ represents a hydrogen atom, an alkyl group, a cycloalkyl group, a cycloalkylalkyl group, an aralkyl group or an aryl group; and $R^3$ represents an aryl group, an alkyl group, a cycloalkyl group, a cycloalkylalkyl group, an aralkyl group or a substitution product thereof).

Specific examples of the β-diketone include acetylacetone, perfluoroacetylacetone, benzoyl-2-furanoylmethane, 1,3-bis(3-pyridyl)-1,3-propanedione, benzoyltrifluoroacetone, benzoylacetone, 5-chlorosulfonyl-2-tenoyltrifluoroacetone, di(4-bromo)benzoylmethane, dibenzoylmethane, d,d-dicamphorylmethane, 1,3-dicyano-1,3-propanedione, p-bis(4,4,5,5,6,6,6-heptafluoro-1,3-hexanedinoyl)benzene, 4,4'-dimethoxydibenzoylmethane, 2,6-dimethyl-3,5-heptanedione, dinaphthoylmethane, dipivaloylmethane, bis(perfluoro-2-propoxypropionyl)methane, 1,3-di(2-thienyl)-1,3-propanedione, 3-(trifluoroacetyl)-d-camphor, 6,6,6-trifluoro-2,2-dimethyl-3,5-hexanedione, 1,1,1,2,2,6,6,7,7,7-decafluoro-3,5-heptanedione, 6,6,7,7,8,8,8-heptafluoro-2,2-dimethyl-3,5-octanedione, 2-furyltrifluoroacetone, hexafluoroacetylacetone, 3-(heptafluorobutyryl)-d-camphor, 4,4,5,5,6,6,6-heptafluoro-1-(2-thienyl)-1,3-hexanedione, 4-methoxydibenzoylmethane, 4-methoxybenzoyl-2-furanoylmethane, 6-methyl-2,4-heptanedione, 2-naphthoyltrifluoroacetone, 2-(2-pyridyl)benzimidazole, 5,6-dihydroxy-10-phenanthroline, 1-phenyl-3-methyl-4-benzoyl-5-pyrazole, 1-phenyl-3-methyl-4-(4-butylbenzoyl)-5-pyrazole, 1-phenyl-3-methyl-4-isobutyryl-5-pyrazole, 1-phenyl-3-methyl-4-trifluoroacetyl-5-pyrazole, 3-(5-phenyl-1,3,4-oxadiazol-2-yl)-2,4-pentanedione, 3-phenyl-2,4-pentanedione, 3-[3',5'-bis(phenylmethoxy)phenyl]-1-(9-phenanthyl)-1-propane-1,3-dione, 5,5-dimethyl-1,1,1-trifluoro-2,4-hexanedione, 1-phenyl-3-(2-thienyl)-1,3-propanedione, 3-(t-butylhydroxymethylene)-d-camphor, 1,1,1-trifluoro-2,4-pentanedione, 1,1,1,2,2,3,3,7,7,8,8,9,9,9-tetradecafluoro-4,6-nonanedione, 2,2,6,6-tetramethyl-3,5-heptanedione, 4,4,4-trifluoro-1-(2-naphthyl)-1,3-butanedione, 1,1,1-trifluoro-5,5-dimethyl-2,4-hexanedione, 2,2,6,6-tetramethyl-3,5-heptanedione, 2,2,6,6-tetramethyl-3,5-octanedione, 2,2,6-trimethyl-3,5-heptanedione, 2,2,7-trimethyl-3,5-octanedione, 4,4,4-trifluoro-1-(thienyl)-1,3-butanedione (TTA), 1,3-diphenyl-1,3-propanedione, benzoylacetone, dibenzoylacetone, diisobutyroylmethane, dipivaloylmethane, 3-methylpentane-2,4-dione, 2,2-dimethylpentane-3,5-dione, 2-methyl-1,3-butanedione, 1,3-butanedione, 3-phenyl-2,4-pentanedione, 1,1,1-trifluoro-2,4-pentanedione, 1,1,1-triftuoro-5,5-dimethyl-2,4-hexanedione, 2,2,6,6-tetramethyl-3,5-heptanedione, 3-methyl-2,4-pentanedione, 2-acetylcyclopentanone, 2-acetylcyclohexanone, 1-heptafluoropropyl-3-t-butyl-1,3-propanedione, 1,3-diphenyl-2-methyl-1,3-propanedione, 1-ethoxy-1,3-butanedione and the like.

Examples of the nitrogen-containing organic compound, nitrogen-containing aromatic heterocyclic compound and phosphine oxide as the neutral ligand of the rare earth complex include 1,10-phenanthroline, 2,2'-bipyridyl, 2,2'-6,2"-terpyridyl, 4,7-diphenyl-1,10-phenanthroline, 2-(2-pyridyl)benzimidazole, triphenylphosphine oxide, tri-n-butylphosphine oxide, tri-n-octylphosphine oxide, tri-n-butyl phosphate and the like.

The fluorescent substance is more preferably contained in a resin particle (also referred to as a spherical fluorescent body). A monomer compound constituting the resin particle is not particularly limited but is preferably a vinyl compound from the viewpoint of suppressing the scattering of light.

In addition, as a method for making a resin particle contain the fluorescent substance, without particular limitation, a method which is usually used can be used. For example, it can be prepared by preparing a mixture of a monomer compound constituting a resin particle with the fluorescent substance and polymerizing it. Specifically, for example, a mixture containing the fluorescent substance and a vinyl compound is prepared, and then the vinyl compound is polymerized using a radical polymerization initiator, so that a fluorescent material for converting wavelengths can be constituted as a resin particle (spherical fluorescent body) containing the fluorescent substance. In accordance with the present invention, the fluorescent material for converting wavelengths refers to a material in the state of being obtained by polymerizing a vinyl compound containing a fluorescent substance.

The average particle diameter of the fluorescent material for converting wavelengths is preferably 0.001 μm to 600 μm, more preferably 0.005 μm to 300 μm, and further preferably 0.01 μm to 250 μm, from the viewpoint of improving efficiency for light utilization.

The average particle diameter of the fluorescent material for converting wavelengths can be performed by using a laser diffraction scattering particle size distribution measuring device (e.g., LS 13320, manufactured by Beckman Coulter, Inc.).

In accordance with the present invention, as the vinyl compound, which is not particularly limited as long as it is a compound having at least one ethylenically unsaturated bond, an acrylic monomer, a methacrylic monomer, an acrylic oligomer, a methacrylic oligomer or the like, which can become a vinyl resin, particularly an acrylic resin or a methacrylic resin, when subjected to a polymerization reaction, may be used without particular limitation. In accordance with the present invention, mention is preferably made of an acrylic monomer, a methacrylic monomer and the like.

Examples of the acrylic monomer and the methacrylic monomer include acrylic acid, methacrylic acid and alkyl esters thereof, other vinyl compounds that are copolymerizable with them may also be used in combination, and the monomers may be used singly or in combination of two or more kinds.

Examples of the acrylic acid alkyl ester and the methacrylic acid alkyl ester include acrylic acid unsubstituted alkyl esters and methacrylic acid unsubstituted alkyl esters such as methyl acrylate, methyl methacrylate, ethyl acrylate, ethyl methacrylate, butyl acrylate, butyl methacrylate, 2-ethylhexyl acrylate, and 2-ethylhexyl methacrylate; dicyclopentenyl(meth)acrylate; tetrahydrofurfuryl(meth)acrylate; benzyl(meth)acrylate; a compound obtained by reacting a polyhydric alcohol with an α,β-unsaturated carboxylic acid (for example, polyethylene glycol di(meth)acrylate (having a number of ethylene groups of 2 to 14), trimethylolpropane di(meth)acrylate, trimethylolpropane tri(meth)acrylate, trimethylolpro-

EP 2 579 329 A1

pane ethoxytri(meth)acrylate, trimethylolpropane propoxytri(meth)acrylate, tetramethylolmethane tri(meth)aCrylate, tetramethylolmethane tetra(meth)acrylate, polypropylene glycol di(meth)acrylate (having a number of propylene groups of 2 to 14), dipentaerythritol penta(meth)acrylate, dipentaerythritol hexa(meth)acrylate, bisphenol A polyoxyethylene di (meth)acrylate, bisphenol A dioxyethylene di(meth)acrylate, bisphenol A trioxyethylene di(meth)acrylate, bisphenol A decaoxyethylene di(meth)acrylate or the like); a compound obtained by adding an $\alpha,\beta$-unsaturated carboxylic acid to a glycidyl group-containing compound (for example, trimethylolpropane triglicidyl ether triacrylate, bisphenol A diglycidyl ether diacrylate or the like); an esterification product of a polyvalent carboxylic acid (for example, phthalic anhydride) and a substance having a hydroxyl group and an ethylenically unsaturated group (for example, $\beta$-hydroxyethyl(meth) acrylate); urethane(meth)acrylate (for example, a reaction product between tolylene diisocyanate and a 2-hydroxyethyl (meth)acrylic acid ester, a reaction product of trimethylhexamethylene diisocyanate, cyclohexanedimethanol and a 2-hydroxyethyl(meth)acrylic acid ester or the like); an acrylic acid substituted alkyl ester or a methacrylic acid substituted alkyl ester having its alkyl group substituted with a hydroxyl group, an epoxy group, a halogen group or the like; and the like.

In addition, other vinyl monomers that are copolymerizable with acrylic acid, methacrylic acid, an acrylic acid alkyl ester or a methacrylic acid alkyl ester include acrylamide, acrylonitrile, diacetone acrylamide, styrene, vinyltoluene and the like. These vinyl monomers can be used singly or in combination of two or more kinds.

As the vinyl compound in accordance with the present invention, it is preferable to use at least one selected from acrylic acid alkyl esters and methacrylic acid alkyl esters, and it is more preferable to use at least one selected from methyl acrylate, methyl methacrylate, ethyl acrylate and ethyl methacrylate.

In accordance with the present invention, the radical polymerization initiator is preferably used for polymerizing the vinyl compound. As the radical polymerization initiator, a radical polymerization initiator which is usually used may be used without particular limitation. Examples preferably include a peroxide or the like. Specifically, an organic peroxide which generates a free radical due to heat is preferred.

Examples of the organized oxide that can be used include isobutyl peroxide, $\alpha,\alpha'$bis(neodecanoylperoxy)diisopropyl-benzene, cumyl peroxyneodecanoate, di-n-propyl peroxydicarbonate, di-s-butyl peroxydicarbonate, 1,1,3,3-tetramethylbutyl neodecanoate, bis(4-t-butylcyclohexyl)peroxydicarbonate, 1-cyclohexyl-1-methylethyl peroxyneodecanoate, di-2-ethoxyethyl peroxydicarbonate, bis(ethylhexylperoxy)dicarbonate, t-hexyl neodecanoate, dimethoxybutyl peroxydicarbonate, bis(3-methyl-3-methoxybutylperoxy)dicarbonate, t-butyl peroxyneodecanoate, t-hexyl peroxypivalate, 3,5,5-trimethylhexanoyl peroxide, octanoyl peroxide, lauroyl peroxide, stearoyl peroxide, 1,1,3,3-tetramethylbutyl peroxy-2-ethylhexanoate, succinic peroxide, 2,5-dimethyl-2,5-di(2-ethylhexanoyl)hexane, 1-cyclohexyl-1-methylethyl peroxy-2-ethylhexanoate, t-hexyl peroxy-2-ethylhexanoate, 4-methylbenzoyl peroxide, t-butyl peroxy-2-ethylhexanoate, m-toluonoylbenzoyl peroxide, benzoyl peroxide, t-butyl peroxyisobutyrate, 1,1-bis(t-butylperoxy)-2-methylcyclohexane, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-bis(t-butylperoxy)cyclohexanone, 2,2-bis(4,4-dibutylperoxycyclohexyl)propane, 1,1 -bis(t-butylperoxy)cyclododecane, t-hexyl peroxyisopropyl monocarbonate, t-butylperoxymaleic acid, t-butyl peroxy-3,5,5-trimethylhexanoate, t-butyl peroxylaurate, 2,5-dimethyl-2,5-bis(m-toluoylperoxy)hexane, t-butyl peroxyisopropyl monocarbonate, t-butyl peroxy-2-ethylhexyl monocarbonate, t-hexyl peroxybenzoate, 2,5-dimethyl-2,5-bis(benzoylperoxy)hexane, t-butyl peroxyacetate, 2,2-bis(t-butylperoxy)butane, t-butyl peroxybenzoate, n-butyl 4,4-bis(t-butylperoxy)valerate, di-t-butyl peroxyisophthalate, $\alpha,\alpha'$bis(t-butylperoxy)diisopropylbenzene, dicumyl peroxide, 2,5-dimethyl-2,5-bis(t-butylperoxy)hexane, t-butyl cumyl peroxide, di-t-butylperoxy, p-methane hydroperoxide, 2,5-dimethyl-2,5-bis(t-butylperoxy)hexyne, diisopropylbenzene hydroperoxide, t-butyltrimethylsilyl peroxide, 1,1,3,3-tetramethylbutyl hydroperoxide, cumene hydroperoxide, t-hexyl hydroperoxide, t-butyl hydroperoxide, 2,3-dimethyl-2,3-diphenylbutane, and the like.

The amount of the radical polymerization initiator used can be appropriately selected depending on the kind of the vinyl compound, the refraction index of a formed resin particle, and the like, and it is used in a used amount that is usually employed. Specifically, for example, it may be used in 0.1 to 15 parts by mass, and preferably used in 0.5 to 10 parts by mass, based on 100 parts by mass of the vinyl compound.

The fluorescent material for converting wavelengths in accordance with the present invention is obtained by mixing the fluorescent substance and vinyl compound described above, and optionally a radical polymerization initiator such as a peroxide and the like, dissolving or dispersing the fluorescent substance in the vinyl compound, and polymerizing the resultant. The method of mixing is not particularly limited, and for example, mixing may be carried out by stirring. The content of the fluorescent substance may be preferably 0.001 to 30 parts by mass, more preferably 0.01 to 20 parts by mass, and further preferably 0.01 to 10 parts by mass, based on 100 parts by mass of the vinyl compound.

(Dispersion Medium Resin)

The wavelength conversion type photovoltaic cell sealing material according to the present invention contains a dispersion medium resin in which the fluorescent substance or the fluorescent material for converting wavelengths is dispersed. Specific examples of the dispersion medium resin include an acrylic resin, a polycarbonate resin, a polystyrene resin, a polyolefin resin, a polyvinyl chloride resin, a polyethersulfone resin, a polyarylate resin, a polyvinylacetal resin, an epoxy resin, a silicone resin, a fluorine resin, copolymers thereof, and the like.

The dispersion medium resins may be used singly or in combination of two or more kinds.

Such acrylic resins as described above include a (meth)acrylic acid ester resin and the like. Such polyolefin resins include polyethylene, polypropylene and the like. Such polyvinylacetal resins include polyvinyl formal, polyvinyl butyral (PVB resin), modified PVB and the like.

In addition, the (meth)acrylic acid ester resin means a resin having a constitutional unit originating from an acrylic acid ester or a methacrylic acid ester, and examples of the acrylic acid alkyl ester or the methacrylic acid alkyl ester include an acrylic acid unsubstituted alkyl ester or a methacrylic acid unsubstituted alkyl ester; an acrylic acid substituted alkyl ester and a methacrylic acid substituted alkyl ester having its alkyl group substituted with a hydroxyl group, an epoxy group, a halogen group or the like; and the like.

The acrylic acid ester or the methacrylic acid ester is preferably an alkyl ester having from 1 to 10 carbon atoms, more preferably an alkyl ester having from 2 to 8 carbon atoms, of acrylic acid or methacrylic acid.

The acrylic acid ester or the methacrylic acid ester can be specifically exemplified by ethyl methacrylate, butyl methacrylate, 2-ethylhexyl methacrylate, 2-hydroxyethyl methacrylate, cyclohexyl methacrylate, phenyl methacrylate, benzyl methacrylate, methyl acrylate, ethyl acrylate, butyl acrylate, 2-ethylhexyl acrylate, 2-hydroxyethyl acrylate, cyclohexyl acrylate, phenyl acrylate, benzyl acrylate and the like.

The (meth)acrylic acid ester resin may be the acrylic acid ester or the methacrylic acid ester as well as may also be a copolymer using an unsaturated monomer copolymerizable with it.

Such unsaturated monomers as described above include unsaturated acids such as methacrylic acid and acrylic acid; styrene, $\alpha$-methylstyrene, acrylamide, diacetone acrylamide, acrylonitrile, methacrylonitrile, maleic anhydride, phenylmaleimide, cyclohexyl maleimide; and the like, and two or more thereof may also be optionally used.

These unsaturated monomers may be used singly or in combination of two or more kinds.

Among them, the (meth)acrylic acid ester resins preferably have constitutional units originating from methyl acrylate, ethyl acrylate, isobutyl acrylate, n-butyl acrylate, 2-ethylhexyl acrylate, methyl methacrylate and n-butyl methacrylate, and more preferably have constitutional units originating from methyl methacrylate from the viewpoint of durability and versatility.

Examples of the resin which is a copolymer include a (meth)acrylic acid ester-styrene copolymer, an ethylene-vinyl acetate copolymer (hereinafter referred to as EVA), and the like.

The dispersion medium resin is preferably EVA in terms of moisture resistance, a cost and versatility, and is preferably a (meth)acrylic acid ester resin in terms of durability and surface hardness. Further, a combination of EVA and a (meth)acrylic acid ester resin is more preferable from the viewpoint of having the advantages of both.

In EVA, the content of a vinyl acetate unit is preferably 1 to 50 mass%, and preferably 3 to 35 mass% in terms of homogeneous dispersibility of the fluorescent substance in the sealing material.

From the viewpoint of forming the sheet, the content of the vinyl acetate unit in EVA is preferably 10 to 50 mass%, and more preferably 20 to 35 mass%.

EVA, which is commercially available, can be applied, and examples of the commercially available product include Ultrasen manufactured by Tosoh Corporation, Evaflex manufactured by DuPont-Mitsui Polychemicals Co., Ltd., Suntec EVA manufactured by Asahi Kasei Chemicals Corp., UBE EVA Copolymer manufactured by Ube-Maruzen Polyethlene Co., Ltd., Evertate manufactured by Sumitomo Chemical Company, Limited, Novatec EVA manufactured by Japan Polyethylene Corporation, and the like.

When EVA is used together with methyl methacrylate, the content of EVA is preferably 50 parts by mass or more, and more preferably 70 parts by mass or more, based on the total amount of 100 parts by mass of EVA and methyl methacrylate.

Further, the dispersion medium resin may also be a resin having a crosslinked structure, to which a crosslinkable monomer is added.

Examples of the crosslinkable monomer may include a compound obtained by reacting a polyhydric alcohol with an $\alpha, \beta$-unsaturated carboxylic acid (for example, polyethylene glycol di(meth)acrylate (having a number of ethylene group of 2 to 14), trimethylolpropane di(meth)acrylate, trimethylolpropane tri(meth)acrylate, trimethylolpropane ethoxytri(meth) acrylate, trimethylolpropane propoxytri(meth)acrylate, tetramethylolmethane tri(meth)acrylate, tetramethylolmethane tetra(meth)acrylate, polypropylene glycol di(meth)acrylate (having a number of propylene groups of 2 to 14), dipentaerythritol penta(meth)acrylate, dipentaerythritol hexa(meth)acrylate, bisphenol A polyoxyethylene di(meth)acrylate, bisphenol A dioxyethylene di(meth)acrylate, bisphenol A trioxyethylene di(meth)acrylate, bisphenol A decaoxyethylene di(meth)acrylate, or the like); a compound obtained by adding an $\alpha,\beta$-unsaturated carboxylic acid to a glycidyl group-containing compound (for example, trimethylolpropane triglycidyl ether triacrylate, bisphenol A diglycidyl ether diacrylate, or the like); an esterification product of a polyvalent carboxylic acid (for example, phthalic anhydride) and a substance having a hydroxyl group and an ethylenically unsaturated group (for example, $\beta$-hydroxyethyl(meth)acrylate); a urethane (meth)acrylate (for example, a reaction product between tolylene diisocyanate and 2-hydroxyethyl(meth)acrylic acid ester, a reaction product of trimethylhexamethylene diisocyanate, cyclohexanedimethanol and 2-hydroxyethyl(meth)acrylic acid ester, or the like); and the like.

Particularly preferred crosslinkable monomers include trimethylolpropane tri(meth)acrylate, dipentaerythritol tetra(meth)acrylate, dipentaerythritol hexa(meth)acrylate, and bisphenol A polyoxyethylene dimethacrylate. The above-described crosslinkable monomers are used singly or in combination of two or more kinds.

Alternatively, the dispersion medium resin can be made to have a crosslinked structure by adding a radical polymerization initiator to the above-described monomer and polymerizing the resultant by heating or light irradiation. As the radical polymerization initiator, a radical polymerization initiator which is usually used may be used without particular limitation. Examples include the above-mentioned peroxides and the like.

The weight average molecular weight of the dispersion medium resin is preferably 10,000 to 100,000, and more preferably 10,000 to 50,000, from the viewpoint of flowability.

The wavelength conversion type photovoltaic cell sealing material according to the present invention may also optionally contain an ultraviolet absorbing agent, a coupling agent, a plasticizer, a flame retardant, an antioxidant, a light stabilizer, a rust-preventive agent, a processing aid or the like, as well as those described above.

The wavelength conversion type photovoltaic cell sealing material according to the present invention can be produced by using a known technology. For example, a method for molding, into sheet form, a composition, in which at least the fluorescent substance or the fluorescent material for converting wavelengths (spherical fluorescent body), and the dispersion medium resin, and further optionally another additive are melt-kneaded, a method for making the dispersion medium resin into varnish, to which the fluorescent substance or the fluorescent material for converting wavelengths (spherical fluorescent body) is added, followed by molding the resultant into sheet form, and removing a solvent, or the like can be utilized.

Specifically, the wavelength conversion type photovoltaic cell sealing material is obtained by, for example, making two mold release sheets face each other via a spacer, applying the melt-kneaded composition into a gap formed between the two mold release sheets, heat-pressing it from both sides to form a second sealing layer, further performing the same method but forming a first sealing layer that contains no fluorescent substance, laminating the second sealing layer and the first sealing layer, sandwiching them between the mold release sheets, and heat-pressing them from both sides.

<Photovoltaic Cell Module>

In accordance with the present invention, a photovoltaic cell module is constituted by necessary members such as an anti-reflection film (not illustrated), a protective glass 20, the wavelength conversion type photovoltaic cell sealing material 30 mentioned above, a solar cell 10, a sealing material 36 for a back surface, a back film 40, a cell electrode (not illustrated) and a tab line (not illustrated).

The anti-reflection film (not illustrated), the protective glass 20, and the wavelength conversion type photovoltaic cell sealing material 30 according to the present invention, which are present closer to a light incident side than the solar cell 10 among these members, are disposed in this order.

In accordance with the photovoltaic cell module according to the present invention, in order to ensure that external light that enters from any angle is efficiently introduced into a solar cell with reduced reflection loss, it is preferable that the refraction index of the wavelength conversion type photovoltaic cell sealing material 30 is higher than the refraction indices of the light transmissive layers that are disposed closer to the light incident side than the wavelength conversion type photovoltaic cell sealing material 30, that is, the anti-reflection film, the protective glass 20 and the like; and is lower than the refraction indices of the light transmissive layers that are disposed closer to the opposite side from the light incident side than the wavelength conversion type photovoltaic cell sealing material 30, that is, a cell anti-reflection film (not illustrated), the solar cell 10 containing Si and the like.

That is, in accordance with the photovoltaic cell module according to the present invention, the refraction index of the layer disposed at the side closer to the solar cell 10 is desirably equivalent to or higher than the refraction index of the adjacent layer disposed at the light incident side, in the layers disposed on the solar cell 10 and closer to the light incident side than the solar cell 10 (such as the protective glass 20 and the anti-reflection film (not illustrated) disposed closer to the light incident side than the protective glass 20).

Specifically, assuming that the solar cell 10 and the layers disposed closer to the light incident side than the solar cell 10 include m layers (m is 2 or more) and the respective refraction indices of the m layers are $n_1, n_2, ..., n_{m-1}, n_m$ in order from the light incident side, it is desirable that $n_1 \leq n_2 \leq .... \leq n_{m-1} \leq n_m$ be satisfied. Since the wavelength conversion type photovoltaic cell sealing material 30 according to the present invention is configured by two or more sealing layers, the refraction indices of the two or more sealing layers also preferably satisfy this relationship.

Specifically, the light transmissive layers placed closer to the light incident side than the wavelength conversion type photovoltaic cell sealing material 30, that is, the anti-reflection film which has a refraction index of 1.25 to 1.45 and the protective glass 20 which has a refraction index of usually around 1.45 to 1.55 are used. The light transmissive layers placed in the anti-light incident side of the wavelength conversion type photovoltaic cell sealing material, that is, the cell anti-reflection film of the solar cell which has a refraction index of usually around 1.9 to 2.1 and the Si layer or the like constituting the solar cell which has a refraction index of usually around 3.3 to 3.4 are used.

The preferred refraction indices of other layers in the light transmissive layers are as described below. For example, assuming that three layers from the light incident side of the light transmissive layers are layer a, layer b and layer c, it is preferable that the refraction indices na, nb and nc of the respective layers meet or be similar to the following equation (1):

$$nb = (na \cdot nc)^{0.5}$$

The disclosure of Japanese Application No. 2010-120647 is incorporated herein by reference in its entirety. All literatures, patent applications and technical standards described in the present specification are herein incorporated by reference to the same extent as if each individual literature, patent application and technical standard was specifically and individually indicated as being incorporated by reference.

[Examples]

The present invention will be described in more detail below with reference to Examples, but the present invention is not limited to these Examples.

[Example 1]

<Synthesis of Fluorescent Substance>

In 7 ml of ethanol, 200 mg of 4,4,4-trifluoro-1-(thienyl)-1,3-butanedione (TTA) was dissolved, and 1.1 ml of 1M sodium hydroxide was added thereto and mixed. To the foregoing mixed solution, 6.2 mg of 1,10-phenanthroline dissolved in 7 ml of ethanol was added, and the resultant was stirred for one hour, followed by adding 3.5 ml of an aqueous solution containing 103 mg of $EuCl_3 \cdot 6H_2O$ to obtain a precipitate. It was filtered off, washed with ethanol, and dried to obtain a fluorescent substance $Eu(TTA)_3Phen$.

<Preparation of Fluorescent Material for Converting Wavelengths (Spherical Fluorescent Body)>

Using 0.3 part by mass of $Eu(TTA)_3Phen$ obtained above as a fluorescent substance, 60 parts by mass of methyl methacrylate as a vinyl compound, and 0.012 part by mass of n-octanethiol as a chain transfer agent, these are mixed and stirred to prepare a monomer mixture liquid. In addition, 300 parts by mass of ion-exchanged water and 3.65 parts by mass of sodium alkylbenzene sulfonate, G-15, manufactured by Kao Corporation, as a surfactant, were added, the previously-mentioned monomer mixture liquid was added thereto, the resultant was kept at 60°C while stirring it using a flask with a reflux pipe under a nitrogen stream, 0.03 part by mass of potassium persulfate as a radical polymerization initiator was added, emulsion polymerization was carried out for 4 hours, and its temperature was finally increased to 90°C to complete the polymerization reaction.
The thus obtained fluorescent material for converting wavelengths became particulate matter having a primary particle diameter of around 100 nm, which was appropriately subjected to post-treatment with isopropyl alcohol or the like, filtered off, dried, and appropriately sieved to obtain a particulate fluorescent material for converting wavelengths (spherical fluorescent body).

<Preparation of Resin Composition for Converting Wavelengths>

In a roll mill at 90°C, 100 parts by mass of an ethylene-vinyl acetate resin (EVA): NM30PW manufactured by Tosoh Corporation as a transparent dispersion medium resin, 1.5 parts by mass of a peroxide thermal radical polymerization initiator (in the present example, also functions as a crosslinking agent): Luperox 101 manufactured by Arkema Yoshitomi, Ltd., 0.5 part by mass of a silane coupling agent: SZ6030 manufactured by Dow Corning Toray Co., Ltd., and 0.01 part by mass of a fluorescent substance [which was added in the form of a fluorescent material for converting wavelengths (spherical fluorescent body). 1 part by mass of the fluorescent material for converting wavelengths was equivalent to 0.005 part by mass in terms of the fluorescent substance] were knead to obtain a resin composition for converting wavelengths.

<Production of First Sealing Sheet Containing No Fluorescent Substance>

A resin composition was prepared in the same manner as in the preparation of the resin composition for converting wavelengths as described above except that any fluorescent material for converting wavelengths (spherical fluorescent body) was not added. About 6 g of this resin composition was sandwiched between mold release sheets, and a first sealing sheet containing no fluorescent substance, with a thickness of about 328 $\mu$m, was produced by a pressing machine having a hot plate adjusted to 90°C using a stainless spacer.

<Production of Second Sealing Sheet Containing Fluorescent Substance>

A second sealing sheet containing a fluorescent substance, with a thickness of about 272 $\mu$m, was obtained with the resin composition for converting wavelengths, obtained above, in the same manner as in the production of the above-described first sealing sheet except that the thickness of a spacer was changed.

<Production of Wavelength Conversion Type Photovoltaic Cell Sealing Material>

The first sealing sheet and the second sealing sheet described above were sandwiched between mold release sheets to obtain a wavelength conversion type photovoltaic cell sealing material having a two-layer structure by a pressing machine having a hot plate adjusted to 90°C using a stainless spacer. The obtained wavelength conversion type photovoltaic cell sealing material has a thickness of 600 $\mu$m.

<Production of Photovoltaic Cell Sealing Sheet for Back Surface>

A photovoltaic cell sealing sheet for a back surface, with the same composition as that of the first sealing sheet described above, was produced by the same method except that it was adjusted to have a thickness of 600 $\mu$m.

<Production of Wavelength Conversion Type Photovoltaic Cell Module>

The wavelength conversion type photovoltaic cell sealing material described above was mounted on protective glass (tempered glass; manufactured by Asahi Glass Co., Ltd.) so that the first sealing sheet for converting wavelengths containing no fluorescent material (spherical fluorescent body) was brought into contact with the tempered glass, a solar cell designed so as to be able to supply electromotive force to the exterior was mounted thereon, the photovoltaic cell sealing sheet for a back surface and a back film (PET film; trade name: A-4300, manufactured by Toyobo Co., Ltd.) were further mounted thereon, and lamination was carried out under the conditions of a hot plate at 150°C, a vacuum for 10 minutes, and pressurization for 15 minutes using a vacuum pressure laminator for a photovoltaic cell (NPC Incorporated, LM-50x50-S) to produce a photovoltaic cell module in Example 1.

The solar cell designed to be able to supply electromotive force to the exterior was a solar cell in which an electrically-conductive film CF-105 for a photovoltaic cell, manufactured by Hitachi Chemical Company, Ltd., was used, two tab lines (0.14 mm in thickness, 2 mm in width, galvanized) were connected to the front and two tab lines to the back by a specialized application device, and each of these at the front and back was further configured as an external supply line using a horizontal tab line (A-TPS 0.23x6.0, manufactured by Hitachi Cable, Ltd.). In addition, in the solar cell designed to be able to supply electromotive force to the exterior, photovoltaic cell I-V characteristics were obtained prior to modularization using a solar simulator WXS-155S-10, AM1.5G, manufactured by Wacom Electric Co., Ltd., and an I-V curve tracer for a solar simulator, MP-160, manufactured by EKO Instruments Co., Ltd. Jsc (short-circuit current density), measured and obtained according to JIS-C-8914, was regarded as Jsc (cell).

[Example 2]

<Production of Wavelength Conversion Type Photovoltaic Cell Sealing Material Having Two-Layer Structure>

A wavelength conversion type photovoltaic cell sealing material in Example 2 was produced in the same manner as in the production of the first and second sealing sheets in Example 1 except that the thicknesses were changed as listed in Table 1.

<Production of Wavelength Conversion Type Photovoltaic Cell Module>

A wavelength conversion type photovoltaic cell module in Example 2 was produced in the same manner as in Example 1 except that a change into the above-described wavelength conversion type photovoltaic cell sealing material in Examples 2 was made.

[Comparative Examples 1, 2]

<Production of Wavelength Conversion Type Photovoltaic Cell Sealing Material Having One-Structure Layer>

Wavelength conversion type photovoltaic cell sealing materials in Comparative Example 1 and Comparative Example 2 were produced in the same manner as in the production of the second sealing sheet in Example 1 except that the thicknesses were changed as listed in Table 1.

<Production of Wavelength Conversion Type Photovoltaic Cell Module>

The above-described wavelength conversion type photovoltaic cell sealing material in Comparative Example 1 or Comparative Example 2 was mounted on a tempered glass (manufactured by Asahi Glass Co., Ltd.) as a protective glass, a solar cell designed to be able to take an electromotive force to the outside was upward mounted thereon, the photovoltaic cell sealing sheet for a back surface and a PET film (trade name: A-4300, manufactured by Toyobo Co., Ltd.) as a back film were further mounted, and lamination was carried out on the conditions of a hot plate at 150°C, a vacuum for 10 minutes, and pressurization for 15 minutes using a vacuum pressure laminator for a photovoltaic cell (NPC Incorporated, LM-50x50-S) to produce photovoltaic cell modules in Comparative Example 1 and Comparative Example 2.

[Evaluation of Photovoltaic Cell Module]

In the wavelength conversion type photovoltaic cell modules produced as described above, photovoltaic cell I-V characteristics were obtained using a solar simulator WXS-155S-10, AM1.5G, manufactured by Wacom Electric Co., Ltd., and an I-V curve tracer for a solar simulator, MP-160, manufactured by EKO Instruments Co., Ltd. and were regarded as Jsc (module) measured and obtained according to JIS-C-8914. Using this value and premeasured Jsc (cell), ΔJsc was calculated from the following equation:

$$[0084] \quad \Delta Jsc = Jsc (module) - Jsc (cell)$$

The obtained results are summarized in Table 1, and the relationships between the film thicknesses of the wavelength conversion type photovoltaic cell sealing sheets containing the fluorescent materials for converting wavelengths (spherical fluorescent bodies) and ΔJsc are summarized in Fig. 2.
[Table 1]

| | Content of fluorescent substance in dispersion medium resin | Thickness of first sealing sheet (containing no fluorescent substance) | Thickness of second sealing sheet (containing fluorescent substance) | Total thickness of sealing material | ΔJsc |
|---|---|---|---|---|---|
| | [part(s) by mass] | [μm] | [μm] | [μm] | [mA/cm$^2$] |
| Example 1 | 0.01 | 328 | 272 | 600 | 0.536 |
| Example 2 | 0.01 | 600 | 250 | 850 | 0.490 |
| Comparative Example 1 | 0.01 | 0 | 590 | 590 | 0.462 |
| Comparative Example 2 | 0.01 | 0 | 800 | 800 | 0.249 |

As seen in Table 1 and Fig. 2, it was demonstrated that the wavelength conversion type photovoltaic cell sealing material including the two layers containing and not containing the fluorescent substance had a greater wavelength conversion effect, even if the film thickness of the sheet containing the fluorescent substance was 300 μm or less, than

that of the sheet in which the wavelength conversion type photovoltaic cell sealing material included the one layer containing the fluorescent substance and its film thickness was 590 μm. That is, it was revealed that the amount of the fluorescent substance used was reduced to half or less and conversion efficiency was improved.

[Example 3]

<Preparation of Fluorescent Material 2 for Converting Wavelengths (Spherical Fluorescent Body)>

In a 200 ml screw pipe, 0.05 g of the fluorescent substance Eu(TTA)$_3$Phen obtained above, 95 g of methyl methacrylate, 5 g of ethylene glycol dimethacrylate, and 0.5 g of 2,2'-azobis(2,4-dimethylvaleronitrile) as a thermal radical initiator were each metered and put, and were stirred and mixed using an ultrasonic washer and a mix rotor. To a separable flask with a cooling pipe, 500 g of ion-exchanged water and 59.1 g of 1.69% polyvinyl alcohol solution as a surfactant were added and stirred. The previously prepared mixture liquid of methyl methacrylate with ethylene glycol dimethacrylate was added thereto, and the resultant was heated to 50°C and reacted for 4 hours while being stirred at 350 rpm. When the particle diameter of this suspension was measured using Beckman Coulter LS13320 (particle size distribution measuring device by high-resolution type laser diffraction scattering method) manufactured by Beckman Coulter, Inc., the volume mean diameter was 104 μm. A precipitate was filtered off, washed with ion-exchanged water, and dried at 60°C to obtain a fluorescent material 2 for converting wavelengths (spherical fluorescent body) by suspension polymerization.

<Preparation of Resin Composition 2 for Converting Wavelengths>

In a roll mill at 90°C, 100 parts by mass of an ethylene-vinyl acetate resin (EVA): NM30PW manufactured by Tosoh Corporation as a transparent dispersion medium resin, 1.5 parts by mass of a peroxide thermal radical polymerization initiator (in the present example, also functions as a crosslinking agent): Luperox 101 manufactured by Arkema Yoshitomi, Ltd., 0.5 part by mass of a silane coupling agent: SZ6030 manufactured by Dow Corning Toray Co., Ltd., and 1 part by mass of the fluorescent material 2 for converting wavelengths (spherical fluorescent body) obtained above and subjected to the polymerization (1 part by mass of the fluorescent material for converting wavelengths was equivalent to 0.0005 part by mass in terms of the concentration of the fluorescent substance) were knead to obtain a resin composition 2 for converting wavelengths.

<Production of Wavelength Conversion Type Photovoltaic Cell Sealing Material Having Two-Layer Structure>

A wavelength conversion type photovoltaic cell sealing material in Example 3 was produced in the same manner as in the production of the first sealing sheet in Example 1 except that a change into the above-described resin composition 2 for converting wavelengths was made.

<Production of Wavelength Conversion Type Photovoltaic Cell Module>

A wavelength conversion type photovoltaic cell module in Example 3 was produced in the same manner as in Example 1 except that a change into the above-described wavelength conversion type photovoltaic cell sealing material in Example 3 was made.

[Evaluation of Photovoltaic Cell Module]

When the evaluation of the wavelength conversion type photovoltaic cell module in Example 3 was carried out by the above-described method, ΔJsc was 0.73 mA/cm$^2$, so that it was found to be superior in conversion efficiency to that in Example 1.

[Explanations of letters or numerals]

    10    Solar cell
    20    Protective glass
    30    Wavelength conversion type photovoltaic cell sealing material
    32    First sealing layer
    34    Second sealing layer

36    Sealing material for back surface
40    Back film

**Claims**

1.  A wavelength conversion type photovoltaic cell sealing material comprising:

    a first sealing layer that contains no fluorescent substance; and
    a second sealing layer that contains a fluorescent substance.

2.  The wavelength conversion type photovoltaic cell sealing material according to claim 1, wherein the fluorescent substance is a europium complex.

3.  The wavelength conversion type photovoltaic cell sealing material according to claim 1 or claim 2, wherein the fluorescent substance is contained in a resin particle with a vinyl compound as a monomer compound.

4.  A photovoltaic cell module comprising:

    a solar cell; and
    the wavelength conversion type photovoltaic cell sealing material according to any one of claim 1 to claim 3, disposed at a light-receiving surface side of the solar cell.

[Fig. 1]

[Fig. 2]

## INTERNATIONAL SEARCH REPORT

| | International application No. |
|---|---|
| | PCT/JP2011/061903 |

A. CLASSIFICATION OF SUBJECT MATTER
*H01L31/042*(2006.01)i, *C09K3/10*(2006.01)i

According to International Patent Classification (IPC) or to both national classification and IPC

B. FIELDS SEARCHED

Minimum documentation searched (classification system followed by classification symbols)
H01L31/042, C09K3/10

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 7-202243 A (Bridgestone Corp.),<br>04 August 1995 (04.08.1995),<br>paragraphs [0032], [0067] to [0069]; fig. 5<br>(Family: none) | 1-2,4<br>3 |
| Y | JP 2009-249445 A (Mitsubishi Chemical Corp.),<br>29 October 2009 (29.10.2009),<br>paragraphs [0169] to [0170]<br>(Family: none) | 1-4 |
| Y | JP 2007-147431 A (Konica Minolta Medical<br>& Graphic, Inc.),<br>14 June 2007 (14.06.2007),<br>paragraphs [0034] to [0042]<br>(Family: none) | 1-4 |

| ☒ Further documents are listed in the continuation of Box C. | ☐ See patent family annex. |
|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>13 June, 2011 (13.06.11) | Date of mailing of the international search report<br>21 June, 2011 (21.06.11) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/061903

C (Continuation).   DOCUMENTS CONSIDERED TO BE RELEVANT

| Category* | Citation of document, with indication, where appropriate, of the relevant passages | Relevant to claim No. |
|---|---|---|
| P,X | JP 2011-014725 A  (Hitachi Chemical Co., Ltd.), 20 January 2011 (20.01.2011), paragraphs [0014] to [0015] (Family: none) | 1-2,4 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000328053 A
- JP 2006303033 A
- JP 2010120647 A

**Non-patent literature cited in the description**

- **MASAYA MITSUISHI ; SHINJI KIKUCHI ; TOKUJI MIYASHITA ; YUTAKA AMANO.** *J. Mater. Chem.,* 2003, vol. 13, 2875-2879